# EUROPÄISCHE PATENTSCHRIFT

(11) **EP 0 442 403 B1**
(45) Veröffentlichungstag und Bekanntmachung des Hinweises auf die Patenterteilung: **12.06.1996**
(21) Anmeldenummer: 91101837.2
(22) Anmeldetag: 09.02.1991
(51) Int. Cl.: G03F 7/40

(54) **Vorrichtung zum Einbrennen von lichtempfindlichen Schichten während der Herstellung von Druckformen**
Method for the burning-in of light-sensitive layers in the manufacturing of printing plates
Procédé pour la cuisson de couches photosensibles en fabriquant des formes d'impression

(30) Priorität: 14.02.1990 DE 4004511
(43) Veröffentlichungstag der Anmeldung: 21.08.1991
(73) Patentinhaber: HOECHST AKTIENGESELLSCHAFT, D-65926 Frankfurt am Main (DE)
(72) Erfinder: Berghäuser, Günter, W-6200 Wiesbaden (DE)

(56) Entgegenhaltungen:
- EP-A- 0 061 059
- DE-U- 8 810 445
- US-A- 2 651 702
- US-A- 4 334 755

## Beschreibung

Die Erfindung betrifft eine Vorrichtung zum Einbrennen von lichtempfindlichen Schichten während der Herstellung von Offsetdruckformen, durch Erhitzen der Druckform, mit einem Strahler, der einen Infrarot-Anteil von 50 bis 87 %, einen im Sichtbaren liegenden Anteil von 10 bis 30 % und einen Ultraviolett-Anteil von 3 bis 20 % in der elektromagnetischen Strahlung aufweist.

Bei positiv arbeitenden lichtempfindlichen Schichten werden die während der bildmäßigen Belichtung der Druckplatte vom Licht getroffenen Teile der lichtempfindlichen Schicht relativ löslicher als die nicht vom Licht getroffenen Teile. Durch das Herauslösen der erstgenannten Teile im Entwicklungsschritt entstehen auf der Druckplattenoberfläche nach dem Entwickeln der belichteten Schicht die beim Drucken wasserführenden Nichtbildstellen der späteren Druckform und aus den letztgenannten Teilen die beim Drucken farbführenden Bildstellen. In der Praxis hat es sich herausgestellt, daß eine Erhitzung der belichteten und entwickelten Druckplatte - je nach Art des Trägermaterials auf Temperaturen von etwa 180 °C und mehr - von der Seite der lichtempfindlichen Schicht oder auch von der Rückseite her zu höheren Druckauflagen führen kann; dieser Vorgang wird als "Einbrennen" bezeichnet. Dafür scheinen zwei Faktoren ausschlaggebend zu sein: Einerseits findet eine mechanische Verfestigung der Bildstellen statt, so daß diese beim Lagern und Drucken, etwa durch Lichteinwirkung, weniger leicht beschädigt werden können; andererseits werden die Bildstellen auch gegenüber chemischen oder physikalisch-chemischen Angriffen resistenter, was sich beispielsweise darin zeigt, daß sie von organische Lösemittel enthaltenden Druckfarben oder von Ätzmedien weniger leicht angegriffen werden als nicht-eingebrannte Bildstellen.

Aus dem Stand der Technik sind beispielsweise die folgenden Verfahren und/oder Vorrichtungen zum Einbrennen von lichtempfindlchen Schichten bekannt geworden:

Aus der DE-A 31 10 632 (= EP-B - 0 061 059) ist ein Verfahren zum Einbrennen von belichteten und entwickelten, positiv arbeitenden, Diazoverbindungen enthaltenden lichtempfindlichen Schichten während der Herstellung von Offsetdruckplatten durch Erhitzen der Druckplatte bekannt. Die elektromagnetische Strahlung des Strahlers enthält einen Infrarot-Anteil von 50 bis 87 %, einen im Sichtbaren liegenden Anteil von 10 bis 30 % und einen Ultraviolett-Anteil von 3 bis 20 %, wobei die Druckplatte auf mindestens 180 °C erhitzt wird.

In der DE-PS 854 890 (= US-PS 3 046 121) wird die Nachbehandlung von positiv arbeitenden, Diazoverbindungen enthaltenden lichtempfindlichen Schichten durch Erhitzen der diese Schichten aufweisenden Druckplatten beschrieben. Das Erhitzen wird vor oder nach der Entwicklung der belichteten Druckplatte durch Behandlung mit Flammen, mit einen heißen Bügeleisen, in einem elektrisch auf höhere Temperaturen beheizten Kasten oder zwischen beheizten Walzen bewirkt; die unbelichtete Diazoverbindung soll durch das Erhitzen zersetzt, und das Zersetzungsprodukt fest mit den Trägermaterial verbunden werden.

Aus der DE-AS 14 47 963 (= GB-PS 1 154 749) ist ein Verfahren zum Herstellen einer Offsetdruckform bekannt, bei dem die Druckplatten mit positiv arbeitenden, o-Naphthochinondiazidverbindungen enthaltenden lichtempfindlichen Schichten nach dem Entwickeln in Gegenwart eines Novolaks und/oder eines Resols auf eine Temperatur von mindestens 180 °C erhitzt werden. Das Harz ist entweder bereits in der lichtempfindlichen Schicht vorhanden oder wird vor dem Erhitzen in Lösung auf die lichtempfindliche Schicht aufgebracht. Die Höhe der Erhitzungstemperatur und die Erhitzungsdauer werden so gewählt, daß durch Zersetzen der farbführenden, nicht vom Licht getroffenen Bildstellen ein Niederschlag auf den beim Drucken wasserführenden, d.h. durch den Entwickler entfernten, vom Licht getroffenen Teilen der Druckplatte entsteht. Durch eine Nachbehandlung werden dann diese beim Drucken wasserführenden Teile der Druckplatte wieder gesäubert. Die Erhitzungstemperatur liegt insbesondere bei 200° bis 250 °C. Die zugehörige Erhitzungsdauer beträgt 5 bis 60 min; wobei die Erhitzung in einem Einbrennofen durchgeführt wird.

Die Vorrichtung zum Einbrennen von Druckplatten mit einer belichteten und entwickelten Diazoschicht gemäß der DE-PS 19 55 378 (= GB-PS 1 330 139) arbeitet bei einer Erhitzungstemperatur von mindestens 180 °C und enthält als Erhitzungselement eine Quarz-Halogen-Lampe mit einem im sichtbaren Spektralbereich liegenden Strahlungsanteil von 10 bis 15 %. Diese Quarz-Halogen-Lampen sollen sich gegenüber Wärmeschränken oder Infrarot(IR)-Heizstäben durch eine relativ kurze Aufheizzeit auszeichnen. Verglichen mit IR-Heizstäben haben sie einen erheblich höheren Strahlungsanteil im sichtbaren Spektralbereich.

Beim Verfahren zur Herstellung von Flachdruckformen nach der DE-OS 22 01 936 (= GB-PS 1 413 374) werden die belichteten und entwickelten lichtempfindlichen Schichten von der Rückseite der Druckplatte her mit IR-Strahlung erwärmt, wobei diese Rückseite eine IR-absorbierende Schicht trägt.

In dem DE-GM 69 01 603 (= US-PS 3 589 261) wird eine Vorrichtung zum Entwickeln von negativ-arbeitenden, fotopolymerisierbare Verbindungen enthaltenden lichtempfindlichen Schichten auf flexiblen Trägermaterialien beschrieben, die auch (Seite 3, Absatz 4; Seite 5, Absatz 1; Seite 9, Absatz 4 und Seite 10) eine Nachbelichtungsstufe umfaßt, wobei UV(Ultraviolett)- und IR-Licht abstrahlende Lampen zum Einsatz kommen. In dieser Stufe soll einerseits das Material nach der Hauptentwicklungsstufe getrocknet werden und andererseits eine Nachbelichtung der verbliebenen fotopolymerisierbaren Anteile in den Bildstellen stattfinden.

Aus den DE-GM 72 02 150 und 78 05 619 ist es bekannt, daß in der Praxis im wesentlichen drei Arten von Einbrennschränken für Druckplatten eingesetzt werden, nämlich horizontal oder vertikal arbeitende Umluft-Einbrennschränke oder vertikal arbeitende Einbrennöfen mit Erhitzungseinrichtungen auf der Basis elektromagnetischer Strahlung; auch eine Erhitzung der lichtempfindlichen Schicht über das Auflegen der Druckplatten auf einen beheizten Zylinder ist möglich.

Die aus dem Stand der Technik bekanntgewordenen Einbrennverfahren weisen aber folgende Nachteile auf:
- Die Vorrichtungen, die mit offener Flamme arbeiten, oder bei denen beheizte Walzen verwendet werden, liefern hinsichtlich der erzeugten Temperatur nur ungenügend reproduzierbare Wärmeverteilungen, es können Beschädigungen von Teilen der Druckplatten auftreten, und es kommt kein gleichmäßiges Einbrennen der Schicht zustande.
- Die Vorrichtungen, bei denen in einem Wärmeschrank beispielsweise mit erwärmter Umluft gearbeitet wird, führen zwar zu einer besser reproduzierbaren Temperatureinstellung und zu einer Vergleichmäßigung des Einbrennens, es müssen jedoch lange Aufheizzeiten vor und während des Einbrennens in Kauf genommen werden, und es kann, insbesondere bei Druckplatten-Trägermaterialien auf der Basis organischer Polymerer oder aus Aluminium, zu einer negativen Beeinflussung der mechanischen Festigkeit (z.B. der Zugfestigkeit) der Trägermaterialien kommen.
- Die Vorrichtungen, bei denen elektromagnetische Strahlung mit einem ausschließlichen oder sehr hohen IR-Anteil eingesetzt wird, können zwar, insbesondere bei einer Reduzierung des Abstands zwischen lichtempfindlicher Schicht und Wärmequelle, zu einer Reduktion der Behandlungszeit von mindestens 5 bis 6 min in sogenannten Einbrennschränken auf beispielsweise etwa 1 min führen, sie haben dann jedoch die unerwünschte Nebenwirkung einer sehr starken negativen Beeinflussung der mechanischen Festigkeit der Druckplatten-Trägermaterialien.

Es war zwar bereits von der Aufarbeitung von belichteten und entwickelten, negativ arbeitenden Druckplatten mit fotopolymerisierbaren Verbindungen in der lichtempfindlichen Schicht her bekannt, diese mit UV- und IR-Licht abstrahlenden Lampen in einer "Nachbelichtungsstufe" zu bestrahlen, aber eine solche Maßnahme verfolgt andere Zwecke. Diese Lampen sollen nämlich einerseits zur Materialtrocknung und andererseits zur Nachbelichtung von noch in den Bildstellen verbliebenen fotopolymerisierbaren Anteilen dienen. Da bei negativ arbeitenden lichtempfindlichen Schichten die von Licht getroffenen Teile der Schicht weniger löslich werden, soll die Bestrahlung mit den, einen UV-Anteil aufweisenden Lampen zu einem vollständigen Unlöslichmachen solcher Bildstellen oder Teilen von Bildstellen führen, die sich z.B. in den der Oberfläche des Trägermaterials benachbarten Bereichen befinden, die weiter von der Lichtquelle in der eigentlichen Belichtungsstufe entfernt sind, soweit diese noch nicht oder nur ungenügend unlöslich waren. Dies bedeutet aber, daß eine nicht-erfinderische Übertragung dieser Lehre auf das Einbrennen von positiv arbeitenden lichtempfindlichen Schichten nicht vorliegt, da bei diesen genau entgegengesetzte Voraussetzungen herrschen. Es mußte zunächst davon ausgegangen werden, daß eine Bestrahlung mit UV-Licht zu einer größeren Löslichkeit der von Licht getroffenen Schichtteile führen müßte.

Die Erfindung geht aus von einer Vorrichtung zum Einbrennen von belichteten und entwickelten, positiv arbeitenden, Diazoverbindungen enthaltenden lichtempfindlichen Schichten während der Herstellung von Druckformen durch Erhitzen der Druckplatte mit einer einen Infrarot-Anteil, einen im Sichtbaren liegenden Anteil und einen Ultraviolett-Anteil aufweisenden elektromagnetischen Strahlung.

Aufgabe der vorliegenden Erfindung ist es, eine Vorrichtung zum Einbrennen von positiv arbeitenden lichtempfindlichen Schichten auf Druckplatten der eingangs beschriebenen Art so zu verbessern, daß sich eine gleichmäßige Wärmeverteilung auf der gesamten Rückseite der Druckform, die von dem Strahler abgewandt ist, einstellt und die mechanischen und thermischen Eigenschaften des Trägermaterials der Druckform, insbesondere von Trägermaterialien auf der Basis von Aluminium, nicht beeinflußt werden.

Diese Aufgabe wird dadurch gelöst, daß ein Strahlungsabsorber vorhanden ist, über den die Druckform mit ihrer Rückseite plangeführt ist, während ihre Schichtseite im konstanten Abstand unter dem Strahler vorbeigeführt wird, und daß der Strahlungsabsorber ein Wärmereservoir abdeckt, das die Wärmeverteilung gleichmäßig und die Temperatur in dem Strahlungsabsorber weitgehend konstant hält.

Die weiter Ausgestaltung der Erfindung ergibt sich aus den Patentansprüchen 2 bis 15.

Die Vorrichtung läßt sich grundsätzlich für jede Offsetdruckplatte anwenden, die in der positiv arbeitenden lichtempfindlichen Schicht mindestens eine Diazoverbindung als lichtempfindliche Komponente enthält, insbesondere sind diese Verbindungen Ester oder Amide von o-Naphthochinondiazidsulfonsäuren oder o-Naphthochinondiazidcarbonsäuren (siehe beispielsweise die bereits eingangs erwähnte DE-AS 14 47 963). Neben der Diazoverbindungs-Komponente enthalten die lichtempfindlichen Schichten normalerweise auch ein Harz, insbesondere einen Novolak und/oder ein Resol, es können aber auch verschiedene weitere Komponenten, wie Farbstoffe oder Haftvermittler, vorhanden sein.

Als Trägermaterialien für die lichtempfindlichen Schichten können die in der Offsetdrucktechnik üblichen verwendet werden, dazu zählen, neben denen für Einbrennverfahren wegen ihrer im allgemeinen ungenügend temperaturstabilen Zusammensetzung weniger geeigneten Folien aus organischen Polymeren, wie Polyestern, insbesondere Metallfolien auf der Basis von Aluminium, Zink oder Stahl; bevorzugt werden Aluminiumplatten eingesetzt, die chemisch, mechanisch oder elektrochemisch aufgerauht sind und gegebenenfalls noch eine Aluminiumoxidschicht tragen. Oftmals wird das Druckplattenträgermaterial auch noch auf der Oberfläche vor dem Aufbringen der lichtempfindlichen Schicht modifiziert, beispielsweise mit wäßrigen Polyvinylphosphonsäure- oder Natriumsilikatlösungen.

In der Praxis des Einbrennens können vor und/oder nach dem thermischen Behandlungsschritt auch noch verschiedenste Hilfsmittel zum Einsatz kommen, dazu zählen beispielsweise:
- wäßrige Fluorwasserstoffsäure, wäßrige Trinatrium-phosphatlösung, wäßrige Phosphorsäure oder wäßrige Borfluorwasserstoffsäure zur Entfernung der beim Einbrennen entstehenden Verunreinigungen an den Nichtbildstellen der Druckplatte bzw. wäßrige Phosphorsäure zur Hydrophilierung der Nichtbildstellen vor dem Einbrennen gemäß der DE-AS 14 47 963 (= GB-PS 1 154 749),
- wäßrige Lösungen von wasserlöslichen organischen Substanzen, wie Gummi arabicum, Celluloseether, Polyacrylsäure, Salze organischer Säuren oder anionogene Tenside, wie Alkylarylsulfonate und/oder von wasserlöslichen anorganischen Salzen, wie Halogenide, Borate, Phosphate oder Sulfate zur Modifizierung der gesamten Plattenoberfläche (mit besonderer hydrophilierender Wirkung auf die Nichtbildstellen) vor dem Einbrennen gemäß der DE-OS 26 26 473 (= GB-PS 1 555 233),
- eine wäßrige Lösung von Polyvinylphosphonsäure zur Entfernung der beim Einbrennen entstehenden Verunreinigungen an den Nichtbildstellen der Druckplatte gemäß der DE-OS 28 55 393.

Die Erfindung wird im folgenden anhand der Zeichnungen näher erläutert. Es zeigen:
- Fig. 1: einen schematischen Querschnitt durch eine erste Ausführungsform der Vorrichtung nach der Erfindung;
- Fig. 2: einen schematischen Längsschnitt durch eine zweite Ausführungsform der Vorrichtung nach der Erfindung; und
- Fig. 3: eine Draufsicht auf ein Drahtgitterband, das in der Vorrichtung nach Fig. 1 oder 2 verwendet wird.

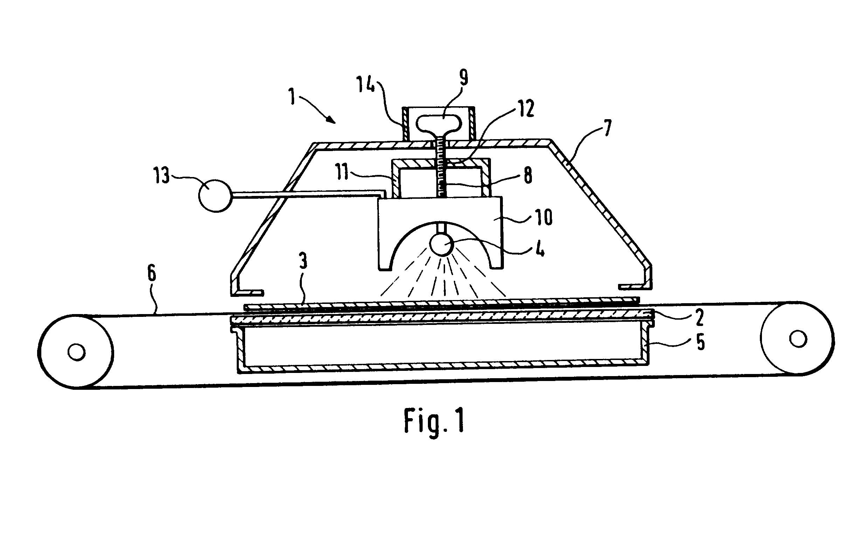

Figur 1 zeigt einen Querschnitt durch eine erste Ausführungsform einer Vorrichtung 1 zum Einbrennen von lichtempfindlichen Schichten auf den Oberflächen von Druckplatten. Die Vorrichtung 1 weist ein Gehäuse 7 auf, das den oberhalb eines Drahtgitterbandes 6 befindlichen Teil der Vorrichtung 1 umschließt. Bei dem Drahtgitterband 6 handelt es sich um ein endlos umlaufendes Drahtgitterband, auf dem das beschichtete Trägermaterial, nämlich eine Druckform 3, aufliegt und unter einem Strahler 4, den das Gehäuse 1 umschließt, hindurchgeführt wird. Der Strahler 4, beispielsweise eine Quecksilberdampflampe, wie sie als UV-Strahler verwendet werden, ist so angeordnet, daß seine gesamte Emission an UV-, IR- und sichtbarer Strahlung ungeschützt auf die darunter durchlaufende Druckform 3 einwirken kann. Der Strahler 4 hat eine variable elektrische Leistungsaufnahme von bis zu maximal 15 kW und ist von einem Reflektor 10 umgeben. Unterhalb des Drahtgitterbandes 6 befindet sich ein Strahlungsabsorber 2, der ein Wärmereservoir 5 abdeckt. Bei dem Transport durch die Vorrichtung 1 liegt die Druckform 3 auf dem Drahtgitterband 6 auf, das plan über den Strahlungsabsorber 2 geführt ist. Die Schichtseite der Druckform 3 wird im konstanten Abstand unter dem Strahler 4 vorbeibewegt.

Für den Strahlungsabsorber 2, bei dem es sich um eine Platte aus einer hitzebeständigen Glaskeramik, die einen thermischen Wärmeausdehnungskoeffizienten α-von -0,15 x 10⁻⁶ x K⁻¹ bis +0,10 x 0,10⁻⁶ x K⁻¹ für einen Temperaturbereich von 20 bis 700 °C besitzt, können im allgemeinen auf dem Markt befindliche Glaskeramiken, beispielsweise der Firma Schott, Mainz, Bundesrepublik Deutschland, oder sonstige technische Keramiken verwendet werden.

Mit dem Strahlungsabsorber 2, der das Wärmereservoir 5 abdeckt, wird eine gleichmäßige Wärmeverteilung im Strahlungsabsorber erzielt und die Temperatur im Strahlungsabsorber konstant gehalten. Wie schon zuvor erwähnt, ermöglicht es der Strahlungsabsorber darüber hinaus, das Drahtgitterband 6 mit der darauf liegenden Druckform 3 plan unter dem Strahler 4 vorbeizuführen. In den Belichtungspausen, d.h. wenn keine Druckform 3 auf dem Drahtgitterband 6 aufliegt, fängt der Strahlungsabsorber 2 die Emission des Strahlers 4 auf und verhindert u.a. Streulicht innerhalb des Gehäuses 7 und somit die unerwünschte Aufheizung von Teilen innerhalb des Gehäuses 7.

Das Drahtgitterband 6 ist um das Wärmereservoir 5 in einer Weise geführt, daß das Obertrum des Drahtgitterbandes oberhalb des Strahlungsabsorbers 2 und das Untertrum des Drahtgitterbandes entlang der Unterseite des Wärmereservoirs 5 verlaufen.

Der Strahlungsabsorber 2 kann beispielsweise dunkel gefärbt sein und eine Oberfläche mit einer leichten Strukturierung besitzen. Die Dicke des Strahlungsabsorbers 2 beträgt 3 bis 5 mm.

Das Wärmereservoir 5 besteht beispielsweise aus einer Blechwanne, die eine Höhe von 5 bis 7 cm hat. Das Wärmereservoir 5 ist mit einem Material gefüllt, hierfür kommen Gase, wie Luft, oder feste Materialien, wie Quarzsand oder Schamottsteine in Frage. Durch die Füllung des Wärmereservoirs 5 wird die der Strahlung abgewandte Rückseite der Druckform 3 thermisch isoliert. Ist in den Wärmereservoir 5 ein ruhendes Luftpolster als Füllung vorhanden, so wird dadurch die Wärmeverteilung im Strahlungsabsorber 2 in besonders großem Maße vergleichmäßigt. Um einen großen Grad von Vergleichmäßigung der Wärmeverteilung im Strahlungsabsorber zu erhalten, kann auch die Rückseite des Strahlungsabsorbers 2, die auf dem Drahtgitterband 6 aufliegt, beispielsweise elektrisch beheizt sein.

Der Strahlungsabsorber 2 in Form einer hitzebeständigen Glaskeramik oder einer sonstigen Industriekeramik gewährleistet automatisch eine ideale plane Führung des Drahtgitterbandes 6 und somit der Druckform 3, darüber hinaus wird ein Material angewandt, das sich weder verwirft noch zu hoch aufheizt und gleichzeitig eine nahezu ideal gleichmäßige Wärmeverteilung auf die Druckform 3 bringt.

Der Strahler 4 ist in einem fest vorgegebenen Abstand von dem Drahtgitterband 6 innerhalb des Gehäuses 7 angeordnet. Dieser fest vorgegebene Abstand richtet sich nach dem jeweiligen Druckplattentyp, d.h. in erster Linie nach der lichtempfindlichen Schicht der Druckform 3.

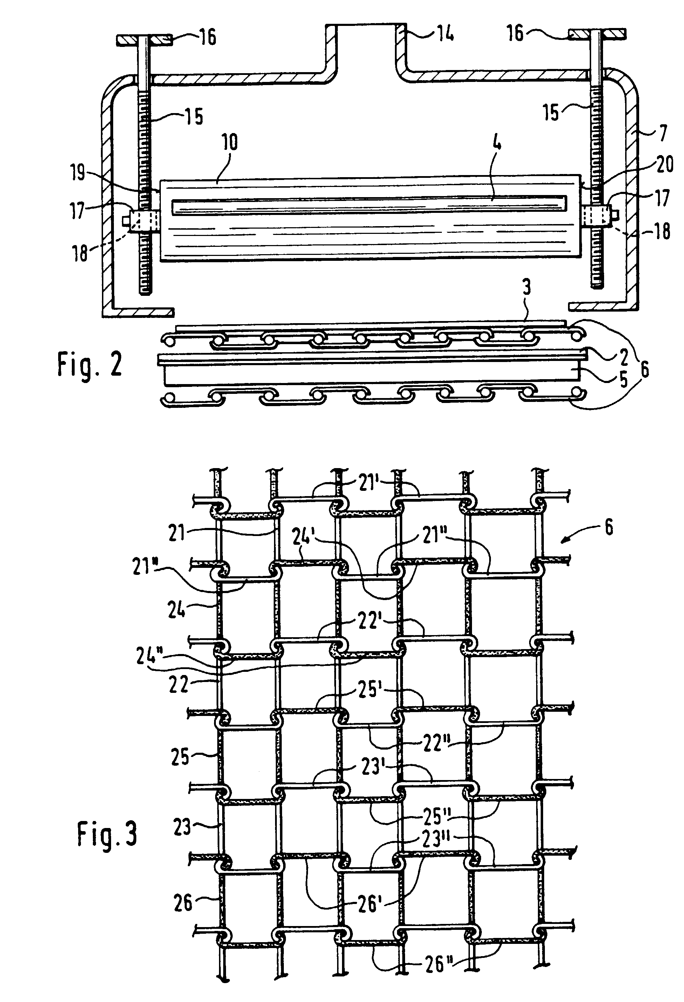

Ausgehend von dem fest vorgegebenen Abstand des Strahlers 4 von der Druckform 3 kann der Strahler 4 in einem Bereich von 0 bis 25 cm in der Höhe bzw. in seinem Abstand von der Druckform 3 verstellt werden. Hierzu ist eine Spindel 8 vorgesehen, die durch das Gehäuse 7 hindurchgeführt ist und die außerhalb des Gehäuses mit einem Griff 9 ausgestattet ist. Innerhalb des Gehäuses befindet sich die Spindel mit einer Halterung 11 des Reflektors 10 des Strahlers 4 im Eingriff. Die Halterung 11 besitzt die Gestalt eines Bügels, dessen beide Enden fest mit dem Reflektor 10 verbunden sind. In der Mitte der Halterung 11 ist eine Gewindebohrung 12 vorhanden, durch die die Spindel 8 hindurchgeführt ist. Das Gewinde der Gewindebohrung 12 ist mit der Spindel im Eingriff. Durch das Drehen der Spindel 8 im oder gegen den Uhrzeigersinn wird die Halterung 11 abgesenkt bzw. angehoben und damit der Abstand des Strahlers 4 von der Druckform 3 eingestellt. Der Reflektor 10 kann aus Metall, einer Glaskeramik oder einer sonstigen Keramik gefertigt sein. Im Falle eines Reflektors 10 aus Glas ist ein Gebläse 13 zum Kühlen des Reflektors 10 mit diesem direkt verbunden. Wird nämlich der Reflektor 10 nicht gekühlt, so kann es zu Verformungen der Metallhalterung kommen, wodurch die Abstrahlungscharakteristik der reflektierten Strahlung des Strahlers 4 erheblich beeinflußt wird, was für die Vergleichmäßigung der Strahlungsverteilung nachteilig ist. Besteht der Reflektor 10 aus einer Glaskeramik oder einer sonstigen technischen Keramik (vgl. Fig. 2), wie sie auch für den Strahlungsabsorber 2 angewandt wird, kann ein derartiges Gebläse weggelassen werden, da diese Keramiken wesentlich höher hitzebeständig als Metalle sind und sich daher unter Wärmeeinwirkung kaum verformen.

Auf der Oberseite des Gehäuses 7 ist ein Absaugstutzen 14 angeordnet, der mit einem nicht dargestellten Absauggebläse verbunden ist, um die beim Einbrennen der lichtempfindlichen Schicht der Druckform 3 freigesetzten Bestandteile sowie das durch den UV-Anteil der Strahlung gebildete Ozon in der Vorrichtung 1 abzusaugen.

Figur 2 zeigt eine zweite Ausführungsform der Vorrichtung 1 nach der Erfindung, die sich gegenüber der ersten Ausführungsform der Vorrichtung nach Figur 1 nur durch die Vertikalverstellung des Strahlers 4 zusammen mit dem Reflektor 10 unterscheidet. In Figur 2 sind der Strahler 4 und der Reflektor 10 im Längsschnitt dargestellt. Der Reflektor 10 besteht aus einer Glaskeramik oder einer sontigen technischen Keramik, wie dies schon voranstehend im Zusammenhang mit der ersten Ausführungsform der Vorrichtung 1 erwähnt wurde. Die Oberfläche der Glaskeramik bzw. sonstigen Keramik des Reflektors 10 ist mit einer dünnen Metallschicht aus Gold, Platin, Silber, Aluminium, Kupfer oder einem sonstigen reflektierenden Metall beschichtet. Durch diese Ausgestaltung des Reflektors 10 für den Strahler 4 entfällt die Notwendigkeit einer Kühlung des Reflektors mittels eines Gebläses. Die Verstellung des Strahlers 4 zusammen mit dem Reflektor 10 erfolgt mittels zweier Spindeln 15, die durch das Gehäuse 7 der Vorrichtung 1 hindurchgeführt sind und jeweils mit einem Griff 16 ausgestattet sind. Die Spindeln 16 sind parallel zu den Breitseiten 19, 20 des Reflektors 10 angeordnet und stehen mit Gewinden in Klötzchen 17, 17 in Eingriff, die mit den Breitseiten 19, 20 fest verbunden sind. Durch die symmetrische Anordnung der Spindeln 15 ist es möglich, jede Breitseite des Reflektors 10 für sich höhenmäßig zu verstellen, d.h. den Abstand von der Druckform 3 individuell zu regeln. Es ist dadurch möglich, Ungleichmäßigkeiten in der Abstrahlungscharakteristik des Strahlers 4, die sich nach längerer Betriebszeit einstellen können, durch unterschiedliche Abstandseinstellungen der Breitseiten 19, 20 des Reflektors 10 zu der Druckform 3, oder mit anderen Worten, durch eine geringe Neigung des Strahlers 4 gegenüber der Durchlaufebene der Druckform 3, bis zu einem bestimmten Maße auszugleichen. Das Gehäuse 7 der zweiten Ausführungsform ist ebenso wie die erste Ausführungsform mit einem Absaugstutzen 14 ausgestattet. Die übrigen Bauteile der zweiten Ausführungsform stimmen weitgehend mit den entsprechenden Teilen der ersten Ausführungsform überein und werden daher nicht nochmals beschrieben.

Figur 3 zeigt eine Draufsicht auf das Drahtgitterband 6, wie es in beiden Ausführungsformen der erfindungsgemäßen Vorrichtung 1 zum Einsatz kommt. Dieses Drahtgitterband 6 besteht aus zwei Gruppen von zueinander parallelen Drähten 21, 22, 23 bzw. 24, 25, 26. Jeder dieser Drähte hat eine Form, die aus gleichgroßen Rechteck- oder Quadratteilen 21', 22', 23', 24', 25', 26' besteht, die nach unten offen sind. Diese Rechteck- oder Quadratteile sind durch gleichgroße, gerade Drahtabschnitte 21'', 22'', 23'', 24'', 25'', 26'' miteinander verbunden. Die Form des einzelnen Drahtes ist am ehesten mit einer elektromagnetischen Welle aus Rechteck- oder quadratischen Impulsen vergleichbar. Die Drähte 21, 22, 23, 24, 25, 26 sind ineinander verflochten und bilden das Geflecht des Drahtgitterbandes 6. Die Verflechtung wird anhand dreier benachbarter Drähte 21, 24 und 22 näher erläutert. Der horizontale Schenkel des linken, ersten Rechteckteils 24' des Drahtes 24 umschließt die beiden vertikalen Schenkel des ersten Rechteckteils 21' des Drahtes 21 im Bereich ihrer horizontalen Knicke von vorne. Die nach unten gerichteten vertikalen Schenkel des ersten Rechteckteils 24' sind hinter den horizontalen Abschnitten 21'' des Drahtes 21 nach unten geführt. Die Verflechtung des zweiten Rechteckteils 24' des Drahtes 24 mit dem zweiten Rechteckteil 21' des Drahtes 21 erfolgt in der gleichen Weise.

Die Verflechtung des Drahtes 24 mit dem darunter angeordneten Draht 22 geschieht in derselben Reihenfolge wie sie zuvor beschrieben wurde, d.h. der horizontale Schenkel des linken, ersten Rechteckteils 22' des Drahtes 22 liegt vor den beiden vertikalen Schenkeln des ersten Rechteckteils 24' im Bereich ihrer horizontalen Knicke. Die nach unten gerichteten vertikalen Schenkel des ersten Rechteckteils 22' verlaufen hinter den vertikalen Schenkeln des ersten Rechteckteils 24'. Die horizontalen Drahtabschnitte 24'' des Drahtes 24 liegen vor den vertikalen Schenkeln 22'.

Diese Verflechtung setzt sich über das gesamte Drahtgitterband 6 hinweg fort.

Die elektromagnetische Strahlung mit einem IR-Anteil, einem im Sichtbaren liegenden und einem UV-Anteil kann mit herkömmlichen Lampen, die UV-Strahlung abgeben, wie sie sonst zur Belichtung von lichtempfindlichen Schichten auf Druckplatten oder von Fotoresists verwendet werden, erzeugt werden. Ähnliche Lampen finden auch in Einrichtungen zur künstlichen Hautbräunung, z.B. in Bräunungsstudios oder in "Heimsonnen", Verwendung. Bevorzugt werden Lampen eingesetzt, deren elektromagnetische Strahlung einen Infrarot-Anteil von 50 bis 87 %, einen im Sichtbaren liegenden Anteil von 10 bis 30 % und einen Ultraviolett-Anteil von 3 bis 20 % aufweist.

Zum UV-Bereich sollen dabei Wellenlängen von etwa 100 nm bis etwa 380 nm und zum IR-Bereich Wellenlängen von etwa 780 nm bis etwa 1 mm gezählt werden. Dafür geeignete Lampen sind insbesondere Quecksilberdampflampen, die auch noch einen gewissen Anteil an Metallhalogeniden, wie Eisenjodid oder Galliumjodid, enthalten können. Der angegebene Bereich für den IR-Anteil bezieht sich auf luftgekühlte Lampen, bei beispielsweise wassergekühlten Lampen sinkt der IR-Anteil signifikant.

Die Vorrichtung kann kontinuierlich oder auch diskontinuierlich betrieben werden, wobei die belichtete und entwickelte Schicht während des Einbrennens zweckmäßig äquidistant zur elektromagnetischen Strahlungsquelle angeordnet wird oder äquidistant an dieser vorbeibewegt wird und die Druckplatte von der Schichtseite her bestrahlt wird, um die thermische Belastung des Schichtträgers möglichst gering zu halten. Die Plattenrückseite wird über ein Metallband mit einem Wärmereservoir bzw. einem Strahlungsabsorber in Kontakt gebracht.

In der Vorrichtung nach der Erfindung wirkt die elektromagnetische Strahlung gleichzeitig und gleichmäßig auf die gesamte Fläche der belichteten und entwickelten Schicht ein, wodurch ein besonders gleichmäßiges Einbrennen aller Bildstellen der Druckplatte und ein möglichst hohen thermischen Wirkungsgrad erzielt werden.

Eine verbesserte Ausnutzung der eingestrahlten Wärmeenergie läßt sich erreichen, wenn die Absorptionsfähigkeit der belichteten und entwickelten Schicht für IR-Strahlung durch Zusatz eines Absorptionshilfsmittels erhöht wird.

Mit der Vorrichtung lassen sich positiv arbeitende lichtempfindliche Schichten in verhältnismäßig kurzer Zeit sehr gleichmäßig einbrennen, ohne dabei die mechanischen Eigenschaften der Trägermaterialien dieser Schichten in größerem Maße negativ zu beeinflussen, dies gelingt bereits bei Einwirkungszeiten der Strahlung - je nach Abstand von der Strahlungsquelle, und der Art der Beschichtung und des Trägermaterials - von etwa 15 bis 90 sec.

In den folgenden Beispielen verhalten sich Gew.-Teile zu Vol.-Teilen wie g zu cm³, die Prozentangaben sind solche in Gew.-%. Es werden bekannte Druckplatten des folgenden Aufbaus eingesetzt:

### Druckplatte Typ 1

Eine mechanisch aufgerauhte Aluminiumfolie wird unter Verwendung einer rotierenden Unterlage zum Abschleudern der überschüssigen Menge der aufgebrachten Lösung mit einer Lösung aus
- 1,5 Gew.-Teilen: des Kondensationsproduktes aus 2,3,4-Trihydroxy-benzophenon und Naphthochinon-(1,2)-diazid-(2)-5-sulfochlorid,
- 0,8 Gew.-Teilen: des Kondensationsproduktes aus 1 Mol 2,2'-Dihydroxy-1,1'-dinaphthylmethan und 2 Mol Naphthochinon-(1,2)-diazid-(2)-5-sulfochlorid,
- 0,6 Gew.-Teilen: eines durch Kondensation eines technischen Kresolgemischs mit Formaldehyd hergestellten Novolaks vom Erweichungspunkt 108° bis 118°C (nach DIN 53 181), und
- 120 Vol.-Teilen: Ethlyenglykolmonomethylether
beschichtet.

### Druckplatte Typ 2

Eine elektrolytisch aufgerauhte und anodisch oxidierte Aluminiumfolie wird mit einer Lösung aus
- 2,17 Gew.-Teilen: des 4-(2-Phenyl-prop-2-yl)phenolesters der Naphthochinon-(1,2)-diazid- (2)-4-sulfonsäure,
- 1,02 Gew.-Teilen: des Kondensationsproduktes aus 1 Mol 2,2'-Dihydroxy-1,1'-dinaphthylmethan und 2 Mol Naphthochinon-(1,2)-diazid-(2)-5-sulfochlorid,
- 0,37 Gew.-Teilen: Naphthochinon-(1,2)-diazid-(2)-4-sulfochlorid,
- 0,12 Gew.-Teilen: Kristallviolett-Base,
- 9,90 Gew.-Teilen: eines Kresol-Formaldehyd-Novolaks -Novolaks vom Erweichungsbereich 112° bis 118°C (nach DIN 53 181),
- 43 Vol.-Teilen: Tetrahydrofuran,
- 35 Vol.-Teilen: Ethylenglykolmonomethylether, und
- 9 Vol.-Teilen: Butylacetat
beschichtet.

### Vergleichsbeispiel V 1

Je eine Druckplatte der Typen 1 und 2 von der Größe 1030 x 800 mm und einer Dicke von 300 µm wird belichtet, entwickelt und während 5 bis 6 min in einem handelsüblichen Einbrennschrank mit heißer Umluft einer Temperatur von 240°C ausgesetzt. Die Beständigkeit der eingebrannten Bildstellen der Druckform wird durch Einwirkenlassen eines Gemisches verschiedener organisches Lösemittel (auf der Basis von Acetanhydrid, Xylol und Dimethylformamid) geprüft. Bei der kürzeren Einbrennzeit sind die Bildstellen beider Druckplattentypen noch löslich, während von den während 6 min eingebrannten Proben die Bildstellen auch nach 5 min Einwirkzeit des Lösemittelgemisches nicht angelöst werden. Die Zugfestigkeit des Trägermaterials geht bei dieser Einbrennzeit von 165 N/mm² auf 140 N/mm² (Verlust von etwa 15 %) zurück.

### Vergleichsbeispiel V 2

Je eine Druckplatte der Typen 1 und 2 von der Größe 1030 x 820 mm und der Dicke von 0,3 mm wird wie im Vergleichsbeispiel V 1 vorbehandelt, mit einer Durchlaufgeschwindigkeit von 1m/min im Abstand von 8 cm unter einem handelsüblichen stabförmigen IR-Brenner durchgeführt und einer Temperatur von 230 °C ausgesetzt. Bei der Überprüfung der Beständigkeit der Bildstellen gemäß den Angaben im Vergleichsbeispiel V 1 werden diese gerade noch, d.h. nach 5 min Einwirkzeit, leicht angelöst. Das Trägermaterial zeigt starke Verspannungen. Seine Zugfestigkeit geht bei dieser Einbrennung von 165 N/ mm² auf 82 N/mm² (Verlust von 50 %) zurück.

Die Druckform ist aufgrund der gestörten Planlage und der unzureichenden Einbrennung nicht gebrauchsfähig.

### Beispiel 1

Je eine Druckplatte der Typen 1 und 2 von der Größe 1030 x 820 mm und der Dicke von 0,3 mm wird, wie im Vergleichsbeispiel V 1 vorbehandelt, mit einer Durchlaufgeschwindigkeit von 1m/min im Abstand von 8 cm der gesamten Emission einer stabförmigen Quecksilberdampflampe, wie sie zur Härtung von UV-Druckfarben eingesetzt wird, ausgesetzt.

Die Bildstellen sind bei der Beständigkeitsprüfung gemäß den Angaben im Vergleichsbeispiel V1 nicht mehr löslich.

Die Zugfestigkeit des Trägermaterials geht bei dieser Einbrennung von 168 N/mm² nur auf 158 N/mm² (Verlust von etwa 6 %) zurück, und die Planlage wird nur unwesentlich beeinflußt.

### Beispiel 2

Eine Druckplatte des Typs 2 wird wie im Vergleichsbeispiel V1 vorbehandelt und die eine Hälfte während 8 min in einem handelsüblichen Einbrennschrank einer Temperatur von 230 °C ausgesetzt und die andere Hälfte gemäß Beispiel 1 mit einer Durchlaufgeschwindigkeit von 1,0 m/min der Emission einer Quecksilberdampfbrenners. Auf beiden Teilen zeigen die auf den Rückseiten aufgeklebten Temperaturmeßstreifen an, daß eine Temperatur von 230 °C erreicht wurde.

Von beiden Druckformen können auf einer handelsüblichen Offset-Druckmaschine mit einem Feuchtwerk, das mit einem Isopropanol/Wasser-Gemisch betrieben wird, etwa 80.000 gute Drucke erstellt werden, d.h. ein Einbrennen von positiv arbeitenden, lichtempfindlichen Schichten nach dem erfindungsgemäßen Verfahren liefert mit signifikant kürzerer und das Trägermaterial schonender Einbrennzeit bei gleicher Schichtzusammensetzung vergleichbare Ergebnisse beim Drucken von diesen Schichten.

## Patentansprüche

1. Vorrichtung zum Einbrennen von lichtempfindlichen Schichten während der Herstellung von Druckformen, durch Erhitzen der Druckform, mit einem Strahler, der einen Infrarot-Anteil von 50 bis 87 %, einen im Sichtbaren liegenden Anteil von 10 bis 30 % und einen Ultraviolett-Anteil von 3 bis 20 % in der elektromagnetischen Strahlung aufweist, dadurch gekennzeichnet, daß ein Strahlungsabsorber (2) vorhanden ist, über den die Druckform (3) mit ihrer Rückseite plan geführt ist, während ihre Schichtseite im konstanten Abstand unter dem Strahler (4) vorbeigeführt wird, und daß der Strahlungsabsorber (2) ein Wärmereservoir (5) abdeckt, das die Wärmeverteilung gleichmäßig und die Temperatur in dem Strahlungsabsorber (2) weitgehend konstant hält.

2. Vorrichtung nach Anspruch 1, dadurch gekennzeichnet, daß ein endlos umlaufendes Drahtgitterband (6) vorhanden ist, auf dem die Druckform (3) während des Durchlaufs durch die Vorrichtung (1) aufliegt, und daß das Obertrum des Drahtgitterbandes (6) oberhalb des Strahlungsabsorbers (2) und das Untertrum des Drahtgitterbandes entlang der Unterseite des Wärmereservoirs (5) geführt sind.

3. Vorrichtung nach Anspruch 1, dadurch gekennzeichnet, daß der Strahlungsabsorber (2) eine Platte aus einer hitzebeständigen Glaskeramik mit einem thermischen Wärmeausdehnungskoeffizienten α-von -0,15 x 10⁻⁶ K⁻¹ bis +0,10 x 0,10⁻⁶ K⁻¹ für einen Temperaturbereich von 20 bis 700 °C ist.

4. Vorrichtung nach Anspruch 3, dadurch gekennzeichnet, daß die Dicke des Strahlungsabsorbers (2) im Bereich von 3,0 bis 5,0 mm liegt.

5. Vorrichtung nach Anspruch 1, dadurch gekennzeichnet, daß das Wärmereservoir (5) aus einer Wanne besteht, deren Füllung die der Strahlung abgewandte Rückseite der Druckform (3) thermisch isoliert.

6. Vorrichtung nach Anspruch 5, dadurch gekennzeichnet, daß in dem Wärmereservoir ein ruhendes Luftpolster vorhanden ist, das die Wärmeverteilung im Strahlungsabsorber (2) vergleichmäßigt.

7. Vorrichtung nach Anspruch 5, dadurch gekennzeichnet, daß das Wärmereservoir (5) mit Quarzsand gefüllt ist.

8. Vorrichtung nach Anspruch 1, dadurch gekennzeichnet, daß der Strahler (4) eine variable elektrische Leistung bis zu 10 kW aufnimmt und in der Höhe, ausgehend von einem fest vorgegebenen Abstand von dem Drahtgitterband (6), in einem Bereich von 0 bis 25 cm verstellbar ist.

9. Vorrichtung nach Anspruch 1, dadurch gekennzeichnet, daß ein Gehäuse (7) den oberhalb des Drahtgitterbandes (6) befindlichen Teil der Vorrichtung (1) umschließt und daß durch das Gehäuse (7) eine Spindel (8) hindurchgeführt ist, die außerhalb des Gehäuses mit einem Griff (9) ausgerüstet ist und innerhalb des Gehäuses mit einer Halterung (11) eines Reflektors (10) des Strahlers (4) im Eingriff steht.

10. Vorrichtung nach Anspruch 9, dadurch gekennzeichnet, daß die Halterung (11) die Gestalt eines Bügels hat, der mit dem Reflektor (10) fest verbunden ist und der in der Mitte eine Gewindebohrung (12) aufweist, durch die die Spindel (8) hindurchgeführt ist und mit deren Gewinde die Spindel im Eingriff steht.

11. Vorrichtung nach Anspruch 9, dadurch gekennzeichnet, daß der Reflektor (10) aus Metall besteht und daß ein Gebläse (13) zum Kühlen des Reflektors (10) vorhanden ist.

12. Vorrichtung nach Anspruch 9, dadurch gekennzeichnet, daß der Reflektor (10) aus einer Glas- oder sonstigen Keramik besteht.

13. Vorrichtung nach Anspuch 1, dadurch gekennzeichnet, daß die Rückseite des Strahlungsabsorbers (2), die auf dem Drahtgitterband (6) aufliegt, beheizt ist.

14. Vorrichtung nach Anspruch 12, dadurch gekennzeichnet, daß der Reflektor (10) mit einem Metall aus der Gruppe Gold, Platin, Silber, Aluminium, Kupfer beschichtet ist.

15. Vorrichtung nach Anspruch 1, dadurch gekennzeichnet, daß zwei Spindeln (15, 15) durch das Gehäuse (7) der Vorrichtung (1) hindurchgeführt sind, daß jede Spindel (15; 15) mit einem Griff (16) ausgestattet ist und daß die Spindeln (15, 15) parallel zu Breitseiten (19, 20) des Reflektors (10) angeordnet sind und mit Gewindebohrungen von Klötzchen (17, 17) im Eingriff sind, die mit den Breitseiten (19, 20) fest verbunden sind.

## Claims

1. A device for burning in light-sensitive layers in the production of printing forms by heating the printing form by means of an emitter which has an infrared fraction of 50 to 87%, a fraction of 10 to 30% in the visible region and an ultraviolet fraction of 3 to 20% in the electromagnetic radiation, wherein a radiation absorber (2) is provided, over which the back of the printing form (3) is guided flat, while the layer side thereof is moved past underneath the emitter (4) at a constant distance, and wherein the radiation absorber (2) covers a heat reservoir (5), which keeps the heat distribution uniform and keeps the temperature in the radiation absorber (2) largely constant.

2. The device as claimed in claim 1, wherein an endless revolving wire mesh band (6) is provided on which the printing form (3) rests while passing through the device (1), and wherein the upper section of the wire mesh band (6) runs above the radiation absorber (2) and the lower section of the wire mesh band runs along the underside of the heat reservoir (5).

3. The device as claimed in claim 1, wherein the radiation absorber (2) is a plate of a heat-resistant glass-ceramic material having a coefficient of thermal expansion a from -0.15 x 10⁻⁶ K⁻¹ to 0.10 x 10⁻⁶ K⁻¹ for a temperature range from 20 to 700°C.

4. The device as claimed in claim 3, wherein the thickness of the radiation absorber (2) is in the range from 3.0 to 5.0 mm.

5. The device as claimed in claim 1, wherein the heat reservoir (5) comprises a trough, whose filling thermally insulates the back of the printing form (3) facing away from the radiation.

6. The device as claimed in claim 5, wherein a static air cushion which evens out the heat distribution in the radiation absorber (2) is present in the heat reservoir.

7. The device as claimed in claim 5, wherein the heat reservoir (5) is filled with quartz sand.

8. The device as claimed in claim 1, wherein the emitter (4) has a variable electric power consumption of up to 10 kW and is height-adjustable in a range from 0 to 25 cm, starting from a fixed preset distance from the wire mesh band (6).

9. The device as claimed in claim 1, wherein a housing (7) encloses the part of the device (1) located above the wire mesh band (6), and wherein a spindle (8) is taken through the housing (7), which spindle is fitted with a handle (9) outside the housing and engages inside the housing with a holder (11) of a reflector (10) of the emitter (4).

10. The device as claimed in claim 9, wherein the holder (11) has the shape of a bracket which is rigidly joined to the reflector (10) and in the middle has a threaded bore (12), through which the spindle (8) is taken, the spindle engaging with the thread thereof.

11. The device as claimed in claim 9, wherein the reflector (10) is composed of metal, and wherein a fan (13) for cooling the reflector (10) is provided.

12. The device as claimed in claim 9, wherein the reflector (10) is composed of glass-ceramic or other ceramic material.

13. The device as claimed in claim 1, wherein the back of the radiation absorber (2), resting on the wire mesh band (6), is heated.

14. The device as claimed in claim 12, wherein the reflector (10) is coated with a metal from the group comprising gold, platinum, silver, aluminum and copper.

15. The device as claimed in claim 1, wherein two spindles (15, 15) are taken through the housing (7) of the device (1), each spindle (15, 15) is fitted with a handle (16) and the spindles (15, 15) are arranged parallel to broad sides (19, 20) of the reflector (10) and engage with threaded bores in little blocks (17, 17) which are rigidly joined to the broad sides (19, 20).

## Revendications

1. Dispositif pour la cuisson de couches photosensibles pendant la fabrication de formes d'impression, par chauffage de la forme d'impression, à l'aide d'un émetteur de rayonnement, qui comporte un pourcentage d'infrarouge de 50 à 87 %, un pourcentage de lumière visible de 10 à 30 % et un pourcentage d'ultraviolets de 3 à 20 % dans le rayonnement électromagnétique, caractérisé en ce qu'il est prévu un absorbeur de rayonnement (2), au-dessus duquel la forme d'impression (3) est guidée à plat par son verso, tandis que sa face portant la couche est déplacée à une distance constante au-dessous de l'émetteur de rayonnement (4), et que l'absorbeur de rayonnement (2) recouvre un réservoir de chaleur (5), qui maintient uniforme la distribution de chaleur et maintient dans une large mesure constante la température dans l'absorbeur de rayonnement (2).

2. Dispositif selon la revendication 1, caractérisé en ce qu'il est prévu une bande circulante sans fin (6) formée d'une grille en fils, et sur laquelle la forme d'impression (3) repose pendant son passage dans le dispositif (1), et que le brin supérieur de la bande (6) formée d'une grille en fils est guidée au-dessus de l'absorbeur de rayonnement (2) et que le brin inférieur de la bande formée de la grille en fils est guidé le long de la face inférieure du réservoir de chaleur (5).

3. Dispositif selon la revendication 1, caractérisé en ce que l'absorbeur de rayonnement (2) est une plaque formé d'un vitrocérame résistant à la chaleur et possédant un coefficient de dilatation thermique α allant de -0,15 x 10⁻⁶ K⁻¹ à +0,10 x 10⁻⁶ K⁻¹ pour une gamme de températures de 20 à 700°C.

4. Dispositif selon la revendication 3, caractérisé en ce que l'épaisseur de l'absorbeur de rayonnement (2) se situe dans la gamme de 3,0 à 5,0 mm.

5. Dispositif selon la revendication 1, caractérisé en ce que le réservoir de chaleur (5) est constitué par une cuvette, dont le remplissage isole, du point de vue thermique, le verso de la forme d'impression (3), qui est tourné à l'opposé du rayonnement.

6. Dispositif selon la revendication 5, caractérisé en ce que dans le réservoir de chaleur est présent un coussin d'air au repos, qui uniformise la distribution de chaleur dans l'absorbeur de rayonnement (2).

7. Dispositif selon la revendication 5, caractérisé en ce que le réservoir de chaleur (5) est rempli de sable quartzeux.

8. Dispositif selon la revendication 1, caractérisé en ce que l'émetteur de rayonnement (4) reçoit une puissance électrique variable atteignant jusqu'à 10 kW et est réglable en hauteur dans une gamme de 0 à 25 cm, à partir d'une distance prédéterminée de façon fixe par rapport à la bande (6) formée d'une grille en fils.

9. Dispositif selon la revendication 1, caractérisé en ce qu'un boîtier (7) entoure la partie du dispositif (1), qui est située au-dessus de la bande (6) formée d'une grille en fils, et que le boîtier (7) est traversé par une broche (8), qui comporte une poignée (9) située à l'extérieur du boîtier et engrène, à l'intérieur du boîtier, avec un organe de fixation (11) d'un réflecteur (10) de l'émetteur de rayonnement (4).

10. Dispositif selon la revendication 9, caractérisé en ce que l'organe de fixation (11) possède la forme d'un étrier, qui est relié de façon fixe au réflecteur (10) et qui possède, en son centre, un perçage taraudé (12), que traverse la broche (8) et avec le taraudage duquel engrène la broche.

11. Dispositif selon la revendication 9, caractérisé en ce que le réflecteur (10) est réalisé en un métal et qu'un ventilateur (13) est prévu pour le refroidissement du réflecteur (10).

12. Dispositif selon la revendication 9, caractérisé en ce que le réflecteur (10) est constitué par un vitrocérame ou une autre céramique.

13. Dispositif selon la revendication 1, caractérisé en ce que le verso de l'absorbeur de rayonnement (2), qui s'applique sur la bande (6) formée d'une grille en fils, est chauffé.

14. Dispositif selon la revendication 12, caractérisé en ce que le réflecteur (10) est recouvert d'un métal tiré du groupe or, platine, argent, aluminium, cuivre.

15. Dispositif selon la revendication 1, caractérisé en ce que deux broches (15,15) traversent le boîtier (7) du dispositif (1), que chaque broche (15;15) est équipée d'une poignée (16) et que les broches (15,15) sont disposées parallèlement aux petits côtés (19,20) du réflecteur (10) et engrènent avec des taraudages de petits blocs (17,17), qui sont reliés de façon fixe aux petits côtés (19,20).
